# EUROPEAN PATENT APPLICATION

(11) **EP 4 765 645 A1**
(43) Date of publication of application: **24.06.2026**
(21) Application number: 24220630.8
(22) Date of filing: 17.12.2024
(51) Int. Cl.: H03K 19/017

(54) **AN INVERTER IN GALLIUM-NITRIDE TECHNOLOGY**

(71) Applicant: Imec VZW, 3001 Leuven (BE); University of Catania, 95131 Catania (IT)
(72) Inventor: Samperi, Katia, 95034 Bronte (IT); Chatterjee, Urmimala, 3012 Wilsele (BE); Pennisi, Salvatore, 95125 Catania (IT)
(74) Representative: Patent Department IMEC

(57) **Abstract**

A Gallium-Nitride inverter is disclosed using only n-type enhancement mode transistors, thereby achieving Direct-Coupled-FET (DCFL) logic.

## Description

### Background

Gallium Nitride has recently drawn the attention as a wide bandgap material to replace narrow bandgap silicon-based CMOS technology. Integrated circuits manufactured in Gallium-Nitride technology provides advantages over silicon-based integrated circuits in the field of power electronics, radiofrequency power amplifiers and - devices.

However, designing complementary logic Integrated Circuits (IC) in Gallium-Nitride (GaN) technology remains challenging. Current Gallium-Nitride technology provides only n-type enhancement (e-mode) and n-type depletion (d-mode) transistors, while exhibiting large process spreads, and lacking p-n junctions and complementary p-type enhancement (e-mode) devices.

A monolithically integrated GaN integrated circuit fully utilizes the fast-switching capability of Gallium-Nitride technology by reducing the inductive parasitic and hence ringing at the gate of the transistor. This enables a fast efficient switching operation and in turn a smooth highly efficient circuit. However, there are challenges at circuit level when realizing an integrated circuit in Gallium-Nitride technology. Due to the absence of a p-type enhancement GaN transistor, such integrated circuits need to be designed by using the n-type enhancement mode (e-mode) GaN transistors only. Therefore, it is not possible to implement a Transistor-Transistor-Logic (TTL) in the design of such a circuit, e.g. an inverter circuit.

One can design an inverter in Gallium-Nitride technology by a series connection of an enhancement mode (e-mode) n-type GaN FET and a resistor. Typically, this series resistor is a two-dimensional electron gas (2DEG) resistor. The pull-up mechanism of such inverter is obtained by using this series resistor which connects the output of the inverter with a higher voltage line. Therefore, the basic building block in this technology becomes a Resistor-Transistor-Logic (RTL) inverter. The performance of such an inverter mainly depends on the optimization of the size of the series resistor, also referred to as load resistor. By increasing the size of this series resistor, it is possible to increase the gain of the inverter and decrease the power dissipation. However, this comes at the penalty of longer time delays in the circuit. Hence, the trade-off between the switching speed and the power dissipation of such an inverter depends on the dimensioning of the series resistor.

One alternative solution for designing an inverter in Gallium-Nitride technology is to replace the 2DEG series resistor with an n-type depletion mode (d-mode) Gallium-Nitride transistor. This is called Direct-Coupled-FET (DCFL) logic. The advantage of DCFL logic over RTL logic is that higher speed is obtained with lower power dissipation. However, from process technology viewpoint, an extra device type is required, i.e. the n-type d-mode logic transistor.

So, there is a need for an inverter in Gallium-Nitride technology requiring a reduced set of device types.

So, there is a need for an inverter in Gallium-Nitride technology without trade-off between switching speed and power dissipation.

### Summary

A Gallium-Nitride inverter (1) comprising: a first e-mode n-type GaN input transistor (2), whose gate (21) is a first input (Vᵢₙ₂) of the inverter (1), and whose drain (23) is connected to the output (Vₒᵤₜ₂) of the inverter (2), this drain (23) is connected to a pull-up network (3), characterised in that the pull-up network (3) comprises at least 3 e-mode n-type GaN transistors (4,5,6) whereby a first e-mode n-type GaN transistor (4) is configured as a diode by connecting its gate (41) to its drain (43), a second e-mode n-type GaN transistor (5) is configured as a capacitor by connecting its source (52) to its drain (53), and a third e-mode n-type GaN transistor (6), whose gate (61) is connected to the source (42) of the first e-mode n-type GaN transistor (4) and to the gate (51) of the second e-mode n-type GaN transistor (5), whose drain (63) is connected to the gate (41) of the first e-mode n-type GaN transistor (4), and whose source (62) is connected to the connected source (52) and drain (53) of the second e-mode n-type GaN transistor (5), and to the drain (23) of the e-mode n-type GaN input transistor (2).

The pull-up network (3) of this Gallium-Nitride inverter (1) can further comprise a resistor (7), inserted in between the first (2) and the third (6) e-mode n-type GaN transistor whereby one end (71) of the resistor (7) is connected to the source (62) of the third e-mode n-type GaN transistor (6), and the opposite end (72) of the resistor (7) is connected to the connected source (52) and drain (53) of the second e-mode n-type GaN transistor (5), and to the drain (23) of the e-mode n-type GaN input transistor (2).

Such invertor can be used to form a logic gate, such as NOT, a NAND and a NOR logic gate. In case of a NAND logic gate, such inverter further comprises a second e-mode n-type GaN input transistor (8), in series with the first e-mode n-type GaN input transistor (2); whose drain (83) is connected to the source (22) of the first e-mode n-type GaN transistor (2), and whose gate (81) is the second input (Vᵢₙ₃) to the inverter (1).

In case of a NOR logic gate, such inverter further comprises a second e-mode n-type GaN input transistor (8), in parallel with the first e-mode n-type GaN input transistor (2); whose drain (83) is connected to drain (23) of the first e-mode n-type GaN input transistor (2), and whose gate (81) is the second input (Vᵢₙ₃) to the inverter (1).

Such invertor and/or any logic gate comprising such an inverter can be used within an integrated circuit.

The e-mode n-type GaN transistor in the inverter and/or logic gate comprising such an inverter can be a HEMT.

### Drawings

FIG I shows an inverter according to prior art
FIG 2 shows an inverter according to an embodiment
FIG 3 shows the comparison between an inverter according to prior art and to an embodiment
FIG 4 shows a NAND logic gate according to an embodiment
FIG 5 shows a NOR logic gate according to an embodiment

### Description

This invention addresses the afore-mentioned problems by implementing Direct-Coupled-FET (DCFL) logic in Gallium-Nitride (GaN) technology without using an n-type depletion mode (d-mode) transistor. The bootstrapped Gallium-Nitride inverter according to this disclosure is particularly useful when the Gallium-Nitride technology only provides an n-type enhancement mode (e-mode) Gallium-nitride transistor, in particular High Electron Mobility Transistor (HEMT), which is often the case in state-of-the-art Gallium-Nitride technology. The pull-up network of the bootstrapped inverter emulates an n-type depletion mode transistor behaviour which is a constant current source. Applying only n-type e-mode Gallium-Nitride transistors as the active components of the inverter and employing the bootstrapping principle, results in an inverter with better performance compared to an inverter that uses a resistive pull-up network as is the case in Resistor-Transistor-Logic (RTL).

FIG I shows a prior art inverter (1) in Gallium-Nitride (GaN) technology, consisting of a series connection of an enhancement mode (e-mode) n-type GaN transistor, in particular a HEMT, (2), also labelled as the pull-down network, and a resistor (8), also labelled as the pull-up network (3). The resistor (8) is connected at one end (82) to the drain (23) of this transistor (2) and at the opposite end (81) to a higher voltage line (V_{dd}). Typically, this series resistor (8) is a two-dimensional electron gas (2DEG) resistor. The pull-up mechanism of such inverter (1) is achieved by this series resistor (8) connecting the output of the inverter (23,82) to this higher voltage line (V_{dd}). Therefore, the basic building block in this technology becomes a Resistor-Transistor-Logic (RTL) inverter.

The n-type e-mode input GaN transistor (2) receives a first input voltage signal (Vᵢₙ₁) at its gate (21). When the input voltage signal biases this gate (21) positive with respect to the source (22) of the transistor (2), current, provided via the resistor (8) from the higher voltage line (V_{dd}), can flow, from the drain (23) of the transistor (2) towards its source (22). The output voltage signal (Vₒᵤₜ₁) at the drain (23) of the transistor (2) is set to the voltage at source (22) of the transistor (2).

When the first input voltage signal (Vᵢₙ₁) biases this gate (21) equal to or negative with respect to the source (22) of the transistor (2), current, provided via the resistor (8) from the higher voltage line (V_{dd}), can no longer flow from the drain (23) of the transistor (2) towards its source (22). The output voltage signal (Vₒᵤₜ₁) at the drain (23) of the transistor (2) is then set to the voltage (V_{dd}) at the opposite end (81) of the resistor (8). The source (22) of the transistor (2) is connected to a lower voltage line (Vₛₛ).

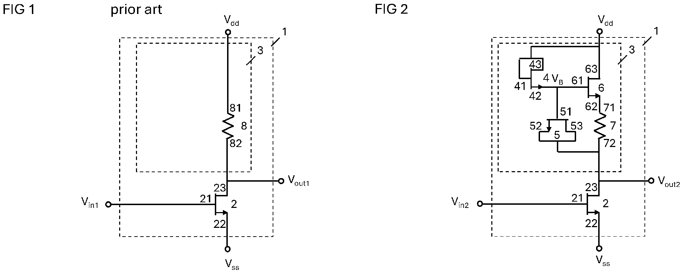

FIG 2 shows an inverter (1) according to an embodiment.

The invertor comprises a pull-down network, consisting of the first input transistor (2), and a pull-up network (3). The pull-up network (3) of this inverter (1) consists of at least three n-type e-mode GaN transistors, in particular HEMT's: a first transistor (4), a second transistor (5) and a third transistor (6) and, optionally, a resistor (7). This resistor is compatible with the Gallium-Nitride technology in which the GaN transistors (2,4,5,6) are manufactured.

In the pull-up network (3), first transistor (4) behaves as a diode as its drain (43) and its gate (41) are connected. Second transistor (5) behaves as a capacitance as its drain (52) and its source (53) are connected. Third transistor (6) provides a current path between the output of the inverter, being the drain (23) of the first input transistor (2), and a higher voltage line (V_{dd}) at the drain (63) of the third transistor (6). The drain (43) of the first transistor (4) is connected to the drain (63) of the third transistor (6), while its source (42) is connected to, both, the gate (61) of the third transistor (6) and to the gate (51) of the second transistor (5). The drain (53) of this second transistor (5) is connected to the drain (23) of the first input transistor (2). The source (22) of the first input transistor (2) is connected to a lower voltage line (Vₛₛ).

Optionally, a resistor (7) is present. This resistor (7) is then inserted between the output of the inverter (1), i.e. the drain (23) of the first input transistor (2), and the source (62) of the third transistor (6). When present, this resistor (7) reduces the current conveyed by the third transistor (6).

When the first input voltage signal (Vᵢₙ₂) at the gate (21) of the first input transistor (2) is high, compared to the voltage at its source (22), the output voltage signal (Vₒᵤₜ₂) at the drain (23) of this transistor (2) is set to the voltage of the source (22) of this transistor (2). Transistor (2) then charges the capacitance-connected second transistor (5) through the diode-connected first transistor (4). The voltage (V_{B}), at the gate (61) of the third transistor (6), increases to the level of the voltage across the capacitance-connected second transistor (5). This voltage level typically is the voltage (V_{dd}) at the drain (63) of the third transistor (6) minus the threshold voltage (V_{th_4}) of the diode-connected first transistor (4): V_{dd} - V_{th_4}. Due to this voltage increase, the third transistor (6) is turned-on, providing current to the drain (23) of the first input transistor (2).

When the first input voltage signal (Vᵢₙ₂) at the gate (21) of the first input transistor (2) is low or negative, compared to the voltage at its source (22), the output voltage signal (Vₒᵤₜ₂) at the drain (23) of this transistor (2) is set to the voltage of the drain (63) of the third transistor (6). The capacitance-connected second transistor (5) cannot discharge now via the first input transistor (2). The voltage (V_{B}), at the gate (61) of the third transistor (6), follows the increase of the output voltage signal (Vₒᵤₜ₂) at the drain (23) of the first input transistor (2). Finally, this voltage (V_{B}) reaches a voltage level of two times the voltage (V_{dd}) at the drain (63) of the third transistor (6) minus the threshold voltage (V_{th_4}) of the diode-connected first transistor (4): 2*V_{dd} - V_{th_4}. As the diode-connected first transistor (4) is now switched off, the voltage at the gate (61) of the third transistor (6) is kept constant. The third transistor (6) now acts alike an n-type depletion-mode (d-mode) transistor.

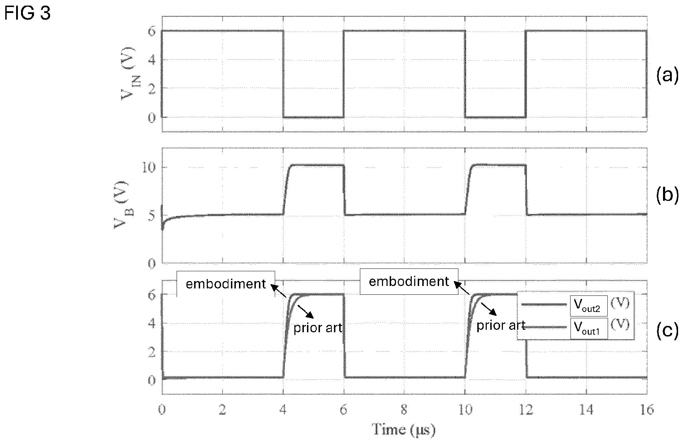

FIG 3 shows the voltage variation for a prior art inverter, as illustrated by FIG 1, and an inverter according to this embodiment, as illustrated by FIG 2. A supply voltage (V_{dd}) of 6 V at the drain (63) of the third transistor (6) is assumed.
FIG 3 (a) shows the variation of the first input voltage signal (Vᵢₙ₁) over time.
FIG 3(b) shows the corresponding variation over time of the voltage (V_{B}) at the gate (61) of the third transistor (6), when the first input voltage signal (Vᵢₙ₁) is low and when the input voltage (Vᵢₙ₁) is high.
FIG 3(c) compares the corresponding variation over time of the output voltage signal (Vₒᵤₜ₂) of the inverter according to this embodiment, illustrated by FIG 2, and of the output voltage signal (Vₒᵤₜ₁) of a prior art inverter, illustrated by FIG 1. The main difference between both output voltage signals lies in the rise time. The invertor according to this embodiment is then faster than the prior art inverter. When the transistor (1) in the pull-down network is off, the current coming from the pull-up network (3) charges the capacitance at the output of the inverter (1) (not shown). For the prior art inverter, the current flowing through resistor (8) decreases as its output voltage (Vₒᵤₜ₁) increases, as defined by Ohm's law, thereby slowing down the low-to-high transition of this output voltage (Vₒᵤₜ₂). For the inverter according to this embodiment, its pull-up network (1) generates a constant current thanks to the bootstrapping principle that biases the third transistor (6) with a constant gate (61)-to-source (62) voltage. Hence the output voltage (Vₒᵤₜ₂) of the inventor according to this embodiment shows a faster low-to-high transition.

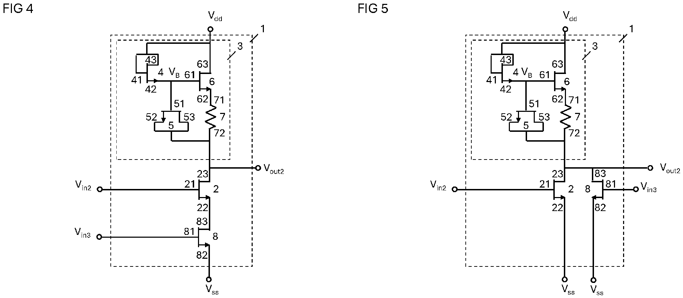

FIG 4 shows a NAND logic gate according to an embodiment. Whereas the inverter circuit shown in FIG 2, only has a first n-type e-mode GaN input transistor (2) receiving the first input voltage signal (Vᵢₙ₂) at its gate (21), this NAND logic gate (1) has a second n-type e-mode GaN input transistor (8), in particular a HEMT. This second input transistor (8) is connected in series between the first input transistor (2) and the lower voltage line (Vₛₛ). The drain (83) of this second input transistor (8) is connected to the source (22) of the first input transistor (2), while the source (82) of this second input transistor (8) is connected to the lower voltage line (Vₛₛ). This second input transistor (8) receives a second input voltage signal (Vᵢₙ₃) at its gate (81).

FIG 5 shows a NOR logic gate according to an embodiment. Whereas the inverter circuit shown in FIG 2, only has a first n-type e-mode GaN input transistor (2) receiving the first input voltage signal (Vᵢₙ₂) at its gate (21), this NAND logic gate (1) has a second n-type e-mode GaN input transistor (8), in particular a HEMT. This second input transistor (8) is connected in parallel to the first input transistor (2). The drain (83) of this second input transistor (8) is connected to the drain (23) of the first input transistor (2), while the source (82) of this second input transistor (8) is connected to the lower voltage line (Vₛₛ). This second input transistor (8) receives a second input voltage signal (Vᵢₙ₃) at its gate (81).

## Claims

1. A Gallium-Nitride inverter (1) comprising:
a first e-mode n-type GaN input transistor (2);
whose gate (21) is a first input (Vᵢₙ₂) of the inverter (1), and
whose drain (23) is connected to the output (Vₒᵤₜ₂) of the inverter (2),
this drain (23) is connected to a pull-up network (3),
**characterised in that**:
the pull-up network (3) comprises at least 3 e-mode n-type GaN transistors (4,5,6) whereby:
a first e-mode n-type GaN transistor (4) is configured as a diode by connecting its gate (41) to its drain (43),
a second e-mode n-type GaN transistor (5) is configured as a capacitor by connecting its source (52) to its drain (53), and
a third e-mode n-type GaN transistor (6),
whose gate (61) is connected to the source (42) of the first e-mode n-type GaN transistor (4) and to the gate (51) of the second e-mode n-type GaN transistor (5),
whose drain (63) is connected to the gate (41) of the first e-mode n-type GaN transistor (4), and
whose source (62) is connected to the connected source (52) and drain (53) of the second e-mode n-type GaN transistor (5), and to the drain (23) of the e-mode n-type GaN input transistor (2).

2. The inverter of claim 1, wherein the pull-up network (3) further comprises
a resistor (7), inserted in between the first (2) and the third (6) e-mode n-type GaN transistor whereby:
one end (71) of the resistor (7) is connected to the source (62) of the third e-mode n-type GaN transistor (6), and
the opposite end (72) of the resistor (7) is connected to
the connected source (52) and drain (53) of the second e-mode n-type GaN transistor (5), and to the drain (23) of the e-mode n-type GaN input transistor (2).

3. A logic gate comprising the inverter of claim 1 or 2.

4. The logic gate of claim 3 being a NOT gate.

5. The logic gate of claim 3, being a NAND gate, further comprising
a second e-mode n-type GaN input transistor (8), in series with the first e-mode n-type GaN input transistor (2);
whose drain (83) is connected to the source (22) of the first e-mode n-type GaN transistor (2), and
whose gate (81) is the second input (Vᵢₙ₃) to the inverter (1).

6. The logic gate of claim 3, being a NOR gate, further comprising
a second e-mode n-type GaN input transistor (8), in parallel with the first e-mode n-type GaN input transistor (2);
whose drain (83) is connected to drain (23) of the first e-mode n-type GaN input transistor (2), and
whose gate (81) is the second input (Vᵢₙ₃) to the inverter (1).

7. A device according to any of the claims I to 6, wherein the e-mode n-type GaN transistor is a HEMT.

8. An integrated circuit comprising at least any of the devices of claims I to 7.
